**Europäisches Patentamt**

**European Patent Office**

**Office européen des brevets**

(19)

(11) Veröffentlichungsnummer : **0 125 446**
**B1**

(12) **EUROPÄISCHE PATENTSCHRIFT**

(45) Veröffentlichungstag der Patentschrift :
**16.06.87**

(21) Anmeldenummer : **84103467.1**

(22) Anmeldetag : **29.03.84**

(51) Int. Cl.⁴ : **C 25 D 5/08**, C 25 D 5/12,
C 25 D 7/00, C 25 D 17/00,
C 25 D 19/00// H05K3/00

(54) Vorrichtung und Verfahren zur galvanischen Abscheidung von Metallen.

(30) Priorität : **13.05.83 DE 3317970**

(43) Veröffentlichungstag der Anmeldung :
**21.11.84 Patentblatt 84/47**

(45) Bekanntmachung des Hinweises auf die Patenterteilung : **16.06.87 Patentblatt 87/25**

(84) Benannte Vertragsstaaten :
**DE FR GB IT SE**

(56) Entgegenhaltungen :
**DE-A- 2 928 904**
**DE-A- 3 235 958**

(73) Patentinhaber : **SCHERING AKTIENGESELLSCHAFT**
**Berlin und Bergkamen**
**Müllerstrasse 170/178 Postfach 65 03 11**
**D-1000 Berlin 65 (DE)**

(72) Erfinder : **Bläsing, Horst**
**Strünkweg 1**
**D-1000 Berlin 13 (DE)**
Erfinder : **Kallweit, Manfred**
**Ragniter Allee 3a**
**D-1000 Berlin 19 (DE)**

## Beschreibung

Die Erfindung betrifft eine Vorrichtung zur galvanischen Abscheidung von Metallen auf das zu galvanisierende, kathodisch geschaltete Werkstück mit übergroßer Geschwindigkeit und steuerbarer Schichtdickenverteilung, bestehend aus einer Elektrolysewanne mit Überlauf, Elektroden, Düsen, verbindenden Rohrleitungen, Pumpen, Steuerungs- und Dosiersystemen sowie elektrischem Zubehör, sowie ein Verfahren zur kontinuierlichen Galvanisierung unter Verwendung dieser Vorrichtung.

Werkstücke, insbesondere Steckkontakte von Leiterplatten, werden in der Regel in Durchlaufanlagen unter Verwendung konventioneller Bäder galvanisch metallisiert.

Die Metallisierung erfolgt im allgemeinen partiell, indem die Plattierungsflüssigkeit gegen die auf eine Transporteinrichtung aufgereihten Werkstücke bzw. Platten geleitet wird.

Infolge ihrer Durchlaufzeiten muß hierbei mit starken Strömen unter ausreichender Elektrolytzufuhr gearbeitet werden, was meist zu unbefriedigenden Schichtdickenverteilungen führt.

In der DE-OS 2 928 904 wird bereits eine Vorrichtung zum Plattieren der Anschlußstifte einer gedruckten Leiterplatte beschrieben, bei der die Plattierungsflüssigkeit aus dem Reservoir durch Löcher geleitet wird, hinter denen eine gekrümmte Folie angebracht ist, welche je nach ihrem Radius die benötigte Konzentration der Flüssigkeit erhöht oder verringert. Das gewährleistet allerdings nicht, daß die Schichtdickenverteilung genau gesteuert werden kann, außerdem entsprechen die erzielten Schichtdicken nicht immer den gestellten Anforderungen.

Aus der DE-A1-3 235 958 ist eine Vorrichtung zum örtlichen Plattieren von Laschen von Leiterplatten oder dergleichen bekannt, bei der der Elektrolyt über Öffnungen aus Düsen auflaufen und auf beide Seiten der zu galvanisierenden, kathodisch geschalteten Leiterplatten prallen kann. Diese Düsen sind als Einkammersysteme gestaltet, deren Öffnungen unverstellbar im rechten Winkel auf die Oberfläche der Leiterplatten gerichtet sind und keine Möglichkeit bieten, die Schichtdickenverteilung zu steuern.

Aufgabe der vorliegenden Erfindung ist daher die Schaffung einer Vorrichtung der eingangs bezeichneten Art, die eine galvanische Abscheidung von Metallen auf das zu galvanisierende kathodisch geschaltete Werkstück mit übergroßer Geschwindigkeit und steuerbarer Schichtdickenverteilung gewährleistet.

Diese Aufgabe wird erfindungsgemäß durch eine Vorrichtung gelöst, welche aus einer Elektrolysewanne (1) mit Überlauf, Elektroden, Düsen, verbindenden Rohrleitungen, Pumpen, Steuerungs- und Dosiersystemen sowie elektrischem Zubehör besteht, die dadurch gekennzeichnet ist, daß das Werkstück (12) zwischen zwei Düsen angeordnet ist, die jeweils aus zwei übereinander befindlichen Kammern (3, 7) mit separaten Zu- (4) und Ableitungen (13, 14) gebildet werden, von denen die obere Kammer (3) eine als länglichen Schlitz gestaltete Elektrolytaustrittsöffnung (6) enthält und die untere Kammer (7) mit einer Anodenblende versehen ist, die eine in der Schlitzhöhe vertikal verstellbare Öffnung (9) aufweist.

Bevorzugte Ausführungsformen der erfindungsgemäßen Vorrichtung bestehen darin, daß die untere Kammer (7) mit einem schachtförmigen Aufbau (11) versehen ist, durch den isoliert angebrachte Anoden (8) bis in die Kammer (7) hineinragen, daß die Düsen vertikal verstellbar angeordnet sind, daß die verstellbare Öffnung (9) der unteren Kammer (7) einen Querschnitt von 300 bis 2 500 mm$^2$ aufweist, daß sich die Austrittsöffnungen (6) der Düsen nahe am Werkstück (12) befinden, daß das Werkstück in einem Abstand von 10 mm von den Düsen angeordnet ist, daß die Austrittsöffnung der oberen Kammer (3) spitzwinklig auf die Oberfläche des Werkstücks (12) gerichtet ist, daß die Vorrichtung vertikal und horizontal verstellbar zum Werkstück (12) angeordnet ist und daß die Einrichtungen zum Transport des Werkstücks (12) in Längsrichtung durch die Elektrolysewanne (1) vorgesehen sind.

Die Aufgabe der Erfindung wird weiterhin durch ein Verfahren zur kontinuierlichen Galvanisierung von kathodisch geschalteten Werkstücken, insbesondere Steckkontakten von Leiterplatten, gelöst, das dadurch gekennzeichnet ist, daß die gekennzeichnete Vorrichtung verwendet wird, daß Nickel- oder Goldüberzüge auf Steckkontakte von Leiterplatten galvanisch abgeschieden werden, daß die galvanische Abscheidung bei Stromdichten von 20 bis 60 A/dm$^2$ erfolgt, daß die Strömungsgeschwindigkeit des Elektrolyten von 1 bis 3 m/S beträgt und daß der Elektrolyt mit einem Überdruck von 0,8 bis 1,0 bar ausgebracht wird.

Die erfindungsgemäße Vorrichtung und das Verfahren ermöglichen bei übergroßer Abscheidungsgeschwindigkeit die Abscheidung porenfreier Niederschläge mit gleichmäßigen Schichtdicken, wobei die Schichtdicke steuerbar ist.

Weitere Vorteile bestehen im Einsatz von löslichen Anoden, wodurch die sonst erforderliche Ergänzung mit dem toxikologisch nicht unbedenklichen Nickelcarbonat vermieden wird, und in der Möglichkeit, beliebig geformte Werkstücke zu Metallisieren. Es versteht sich, daß auch unlösliche Anoden verwendet werden können.

Die Vorrichtung und das Verfahren eignen sich insbesondere zur galvanischen Abscheidung von Nickel und Gold auf Steckkontakte von Leiterplatten im kontinuierlichen Durchlauf.

Als Bäder können an sich bekannte Elektrolytzusammensetzungen verwendet werden, wie zum Beispiel konventionnelle Nickel- und Goldbäder.

Die Düsen bestehen aus zwei Kammern mit getrennten Zuleitungen, die in die bis zum einstellbaren Überlauf geflutete Elektrolysewanne hineinragen.

Die obere Kammer ist als Elektrolytdüse ausgebildet mit den äußeren Elektrolytzuleitungen und der daran befindlichen Verstelleinrichtung sowie dem nach unten zum Werkstück geneigten länglichem Düsenschlitz. Die untere Kammer wird durch eine zum kathodisch geschalteten Werkstück gerichtete, in der Schlitzhöhe vertikal verstellbare Öffnung der Anodenblendenkammer gebildet, in die isoliert angebrachte, lösliche oder unlösliche, Anoden hineinragen. Beide Kammern haben getrennte Zuleitungen, was den besonderen Vorteil hat, daß der starke Elektrolytzulauf nicht direkt auf den Anodenraum wirkt, während andererseits die in den Anodenschächten hineinragenden Anoden nicht mit dem Elektrolyten in der Elektrolytdüse in Berührung kommen.

Die Wirkungsweise der Vorrichtung ergibt sich durch die optimale Einstellung beider Kammern zum Brennpunkt der zu galvanisierenden Fläche des Werkstücks. Zu diesem Zweck ist zweckmäßigerweise die ideale Höhe der Düsen an der Verstelleinrichtung der Elektrolytzuläufe und die Schlitzhöhe der Anodenblendenkammer durch zwei Spindeln während des Betriebs der Vorrichtung oberhalb des Maschinentisches über Skalen einstellbar.

Bei Verwendung von löslichen Anoden kann das eventuelle Verschlammen der Anodenblendenkammer vorteilhafterweise dadurch verhindert werden, daß über einen kleinen Nebenablaufkanal — verbunden mit dem Hauptablauf — durch die Injektorwirkung des Hauptablaufs der Anodenschlamm mit der Strömung stetig durch den Nebenablaufkanal in den Vorratsbehälter geleitet wird.

Als Werkstoffe für die erfindungsgemäße Vorrichtung können die üblichen Materialien eingesetzt werden, soweit diese gegen die einzusetzenden Bäder beständig sind.

Die Steuerung der Vorrichtung kann durch elektronische Systeme erfolgen. Die Vorrichtung selbst kann Bestandteil einer automatischen Anlage, umfassend Transporteinrichtung und Steuerungssystem, sein.

In den Zeichnungen sind Ausführungsbeispiele der Erfindung veranschaulicht.

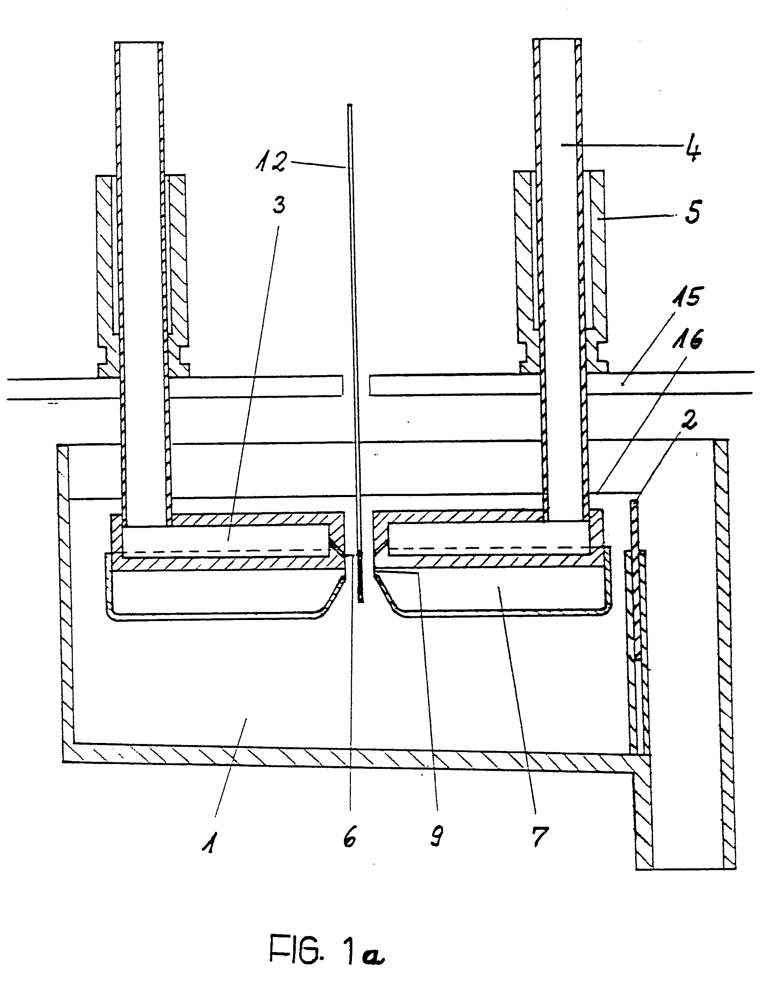

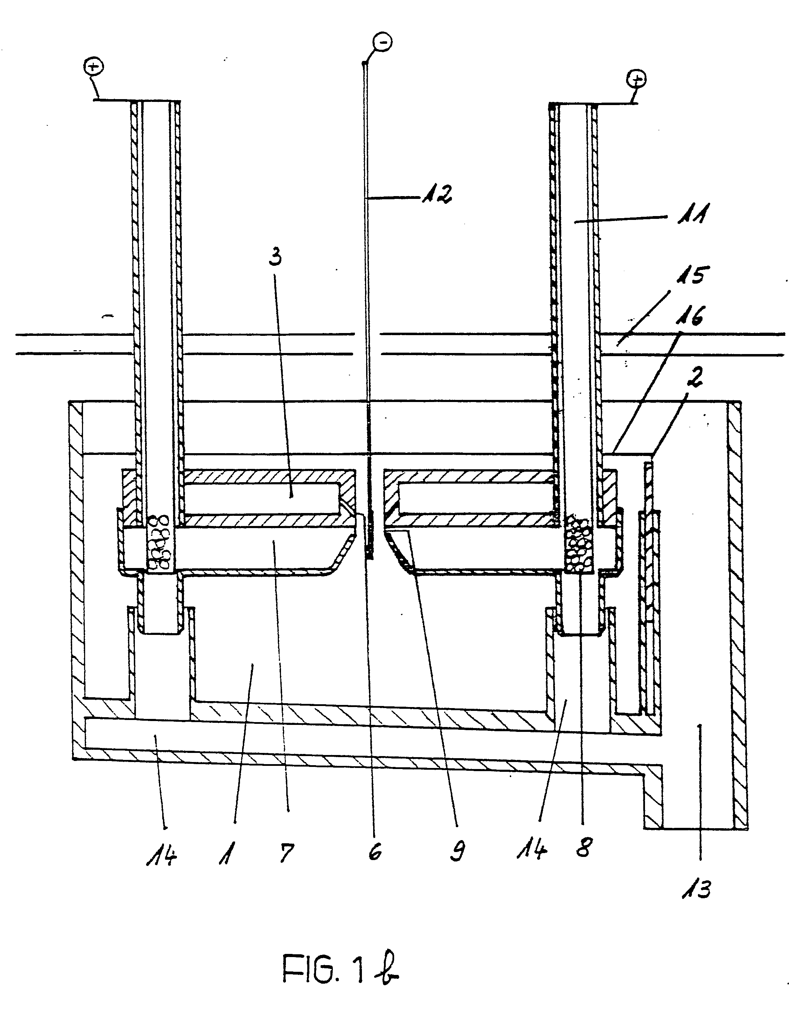

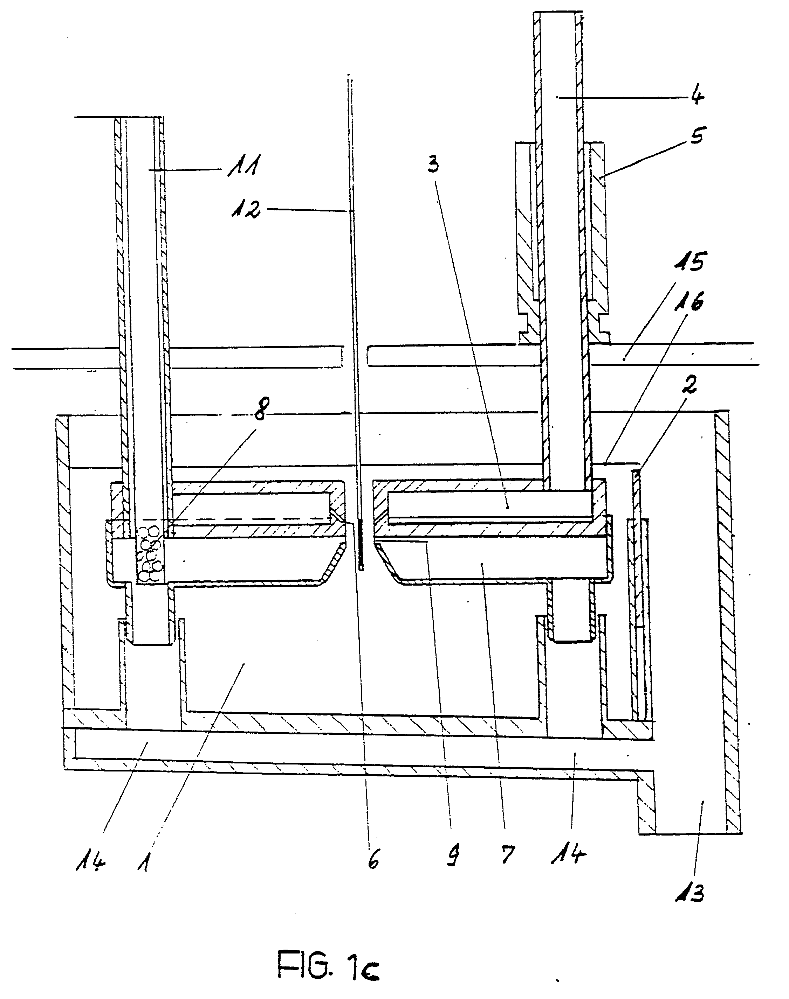

Figur 1a  zeigt die Seitenansicht mit dem Düsenpaar in der Elektrolysewanne mit einem Schnitt durch die jeweils unteren Elektrolytzuleitungen

Figur 1b  zeigt die Seitenansicht mit dem Düsenpaar mit einer Schnittebene durch die Anodenschächte

Figur 1c  zeigt die Seitenansicht mit dem Düsenpaar, die linke Seite mit einer Schnittebene durch den schachtförmigen Aufbau für die Anoden und die rechte Seite durch die Elektrolytzuleitung geschnitten

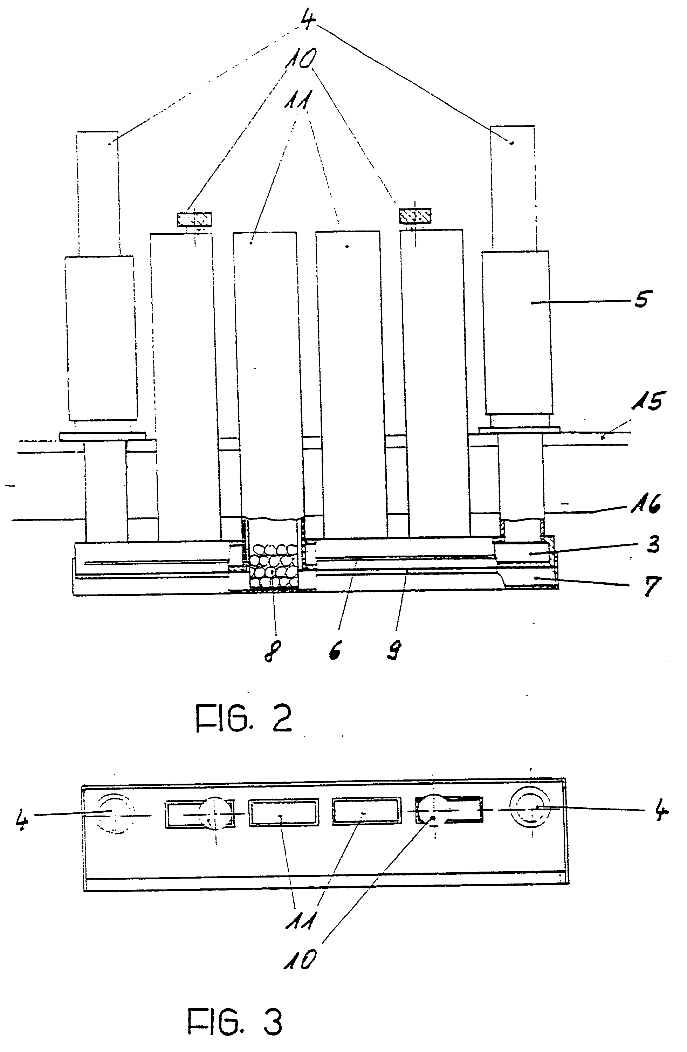

Figur 2  zeigt die Vorderansicht der Düsen

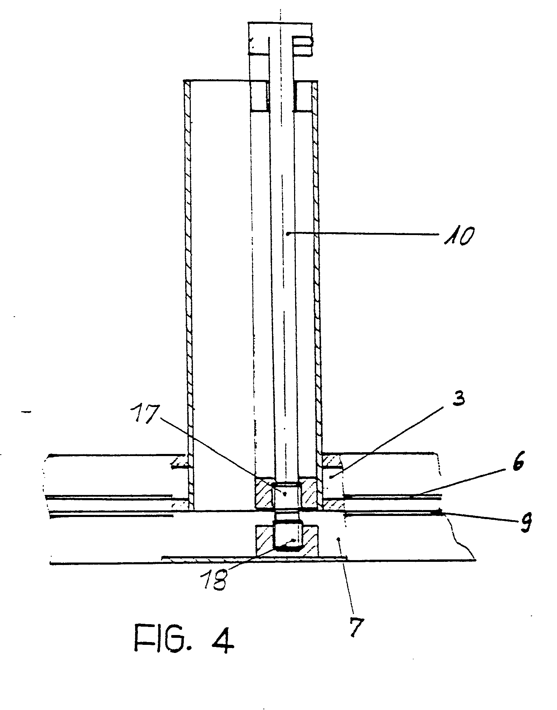

Figur 3  zeigt die Draufsicht der Düsen

Figur 4  zeigt eine Spindel zum Verstellen der

Schlitzbreite der unteren Kammer

Hierin bedeuten :

1 Elektrolysewanne
2 Überlauf
3 obere Kammer
4 Elektrolytzuleitungen
5 Verstelleinrichtung
6 Düsenschlitz
7 untere Kammer
8 Anoden
9 verstellbare Öffnung
10 Spindel zum Verstellen der Schlitzhöhe der unteren Kammer
11 schachtförmiger Aufbau für Anoden
12 Werstück
13 Hauptablauf
14 Nebenablauf
15 Maschinentisch
16 Badspiegel
17 Rechtsgewinde
18 Linksgewinde

## Patentansprüche

1. Vorrichtung zur galvanischen Abscheidung von Metallen auf das zu galvanisierende, kathodisch geschaltete Werkstück mit übergroßer Geschwindigkeit und steuerbarer Schichtdickenverteilung, bestehend aus einer Elektrolysewanne mit Überlauf, Elektroden, Düsen, verbindenden Rohrleitungen, Pumpen, Steuerungs- und Dosiersystemen sowie elektrischem Zubehör, dadurch gekennzeichnet, daß das Werkstück (12) zwischen zwei Düsen angeordnet ist, die jeweils aus zwei übereinander befindlichen Kammern (3, 7) mit separaten Zu- (4) und Ableitungen (13, 14) gebildet werden, von denen die obere Kammer (3) eine als länglichen Schlitz gestaltete Elektrolytaustrittsöffnung (6) enthält und die untere Kammer (7) mit einer Anodenblende versehen ist, die eine in der Schlitzhöhe vertikal verstellbare Öffnung (9) aufweist.

2. Vorrichtung gemäß Anspruch 1, dadurch gekennzeichnet, daß die untere Kammer (7) mit einem schachtförmigen Aufbau (11) versehen ist, durch den isoliert angebrachte Anoden (8) bis in die Kammer (7) hineinragen.

3. Vorrichtung gemäß Anspruch 1, dadurch gekennzeichnet, daß die Düsen vertikal verstellbar angeordnet sind.

4. Vorrichtung gemäß Anspruch 1, dadurch gekennzeichnet, daß die verstellbare Öffnung (9) der unteren Kammer (7) einen Querschnitt von 300 bis 2 500 mm² aufweist.

5. Vorrichtung gemäß Anspruch 1, dadurch gekennzeichnet, daß sich die Austrittsöffnungen (6) der Düsen nahe am Werkstück (12) befinden.

6. Vorrichtung gemäß Anspruch 1, dadurch gekennzeichnet, daß das Werkstück (12) in einem Abstand von 10 mm von den Düsen angeordnet ist.

7. Vorrichtung gemäß Anspruch 1, dadurch gekennzeichnet, daß die Austrittsöffnung der oberen Kammer (3) spitzwinklig auf die Oberfläche des Werkstückes (12) gerichtet ist.

8. Vorrichtung gemäß Anspruch 1, dadurch gekennzeichnet, daß die Vorrichtung vertikal und horizontal verstellbar zum Werkstück (12) angeordnet ist.

9. Vorrichtung gemäß Anspruch 1, dadurch gekennzeichnet, daß Einrichtungen zum Transport des Werkstücks (12) in Längsrichtung durch die Elektrolysewanne (1) vorgesehen sind.

10. Verfahren zur kontinuierlichen Galvanisierung von kathodisch geschalteten Werkstücken, insbesondere Steckkontakten von Leiterplatten, unter Verwendung der Vorrichtung gemäß Ansprüchen 1 bis 9.

11. Verfahren gemäß Anspruch 10, zur galvanischen Abscheidung von Nickel- oder Goldüberzügen auf Steckkontakte von Leiterplatten.

12. Verfahren gemäß Anspruch 10 unter Verwendung von Stromdichten von 20 bis 60 A/dm².

13. Verfahren gemäß Anspruch 10 bei Strömungsgeschwindigkeiten des Elektrolyten von 1 bis 3 m/S.

14. Verfahren gemäß Anspruch 10, wobei der Elektrolyt mit einem Überdruck von 0,8 bis 1,0 bar ausgebracht wird.


## Claims

1. Device for the electrodeposition of metals at an overproportionate rate and with controllable distribution of deposit thickness, which device is comprised of a plating tank with overflow, electrodes, jets, connecting pipes, pumps, control and dosaging systems and electrical accessories, characterized in that the work to be plated, which represents the cathode in the circuit, is arranged between two jets which are formed in each case by two chambers lying one on top of the other with separate inlet and outlet lines, the upper chamber containing an outlet opening for the plating solution in the form of a elongated slot and the lower chamber being provided with an anode diaphragm which has an opening with vertically adjustable slot height.

2. Device in accordance with Claim 1, characterized in that the lower chamber is provided with a shaft-like top through which anodes mounted in an isolated manner project into the chamber.

3. Device in accordance with Claim 1, characterized in that the jets can be vertically adjusted.

4. Device in accordance with Claim 1, characterized in that the adjustable opening in the lower chamber has a cross-section of between 300 and 2 500 mm².

5. Device in accordance with Claim 1, characterized in that the outlet openings of the jets are close to the work.

6. Device in accordance with Claim 1, characterized in that the work is placed at a distance of 100 mm from the jets.

7. Device in accordance with Claim 1, characterized in that the outlet opening of the upper chamber is arranged at an acute angle related to the surface of the work.

8. Device in accordance with Claim 1, characterized in that the device can be shifted in the vertical and the horizontal direction related to the work.

9. Device in accordance with Claim 1, characterized in that equipment is provided for transport of the work in the longitudinal direction of the plating tank.

10. Process for continuous electroplating of articles, in particular connector contacts of printed circuit boards, using the device in accordance with Claims 1 to 9.

11. Device in accordance with Claim 10 for the electrodeposition of nickel and gold coatings on the connector pins of printed circuit boards.

12. Device in accordance with Claim 10 using current densities of between 20 and 60 A/dm².

13. Device in accordance with Claim 10 where the flow rate of the plating solution amounts to between 1 and 3 m/S.

14. Device in accordance with Claim 10 where the plating solution is supplied at an overpressure of between 0.8 and 1.0 bar.


## Revendications

1. Installation pour le dépôt galvanique, ou électrodéposition, à très grande vitesse et avec une répartition réglable de l'épaisseur des couches, de métaux sur la pièce rendue cathodique et qui est à revêtir par électrodéposition, installation consistant en une cuve d'électrolyse avec un déversoir de trop-plein, des électrodes, des buses, des conduits tubulaires de liaison, des pompes, des systèmes de commande et d'introduction dosée ainsi que des accessoires électriques, installation caractérisée en ce que la pièce (12) à traiter est disposée entre deux buses qui sont formées chacune de deux chambres (3, 7) superposées et comportant des conduits séparés d'arrivée (14) et de départ (13, 14), la chambre supérieure (3) contenant un orifice (6) de sortie d'électrolyte en forme de fente longitudinale et la chambre (7) inférieure comportant un écran de protection des anodes qui présente un orifice (9) réglable verticalement dans la hauteur de la fente.

2. Installation selon la revendication 1, caractérisée en ce que la chambre inférieure (7) est équipée d'un élément (11) vertical en forme de tube que les anodes (8) isolées empruntent pour pénétrer dans la chambre (7).

3. Installation selon la revendication 1, caractérisée en ce que les buses sont agencées de manière à pouvoir être réglées en hauteur.

4. Installation selon la revendication 1, caractérisée en ce que l'orifice (9) réglable de la chambre inférieure (7) présente une section de 300 à 2 500 mm².

5. Installation selon la revendication 1, caractérisée en ce que les orifices (6) de sortie des buses se trouvent au voisinage de la pièce (12) à traiter.

6. Installation selon la revendication 1, caractérisée en ce que la pièce (12) à traiter est placée à une distance de 10 mm des buses.

7. Installation selon la revendication 1, caractérisée en ce que l'orifice de sortie de la chambre (3) supérieure forme un angle aigu avec la surface de la pièce (12) à traiter.

8. Installation selon la revendication 1, caractérisée en ce qu'elle est agencée de manière à pouvoir être réglée verticalement et horizontalement par rapport à la pièce (12) à traiter.

9. Installation selon la revendication 1, caractérisée en ce que sont prévus des dispositifs pour transporter dans le sens longitudinal, dans la cuve (1) d'électrolyse, la pièce (12) à traiter.

10. Procédé pour la galvanisation en continu de pièces montées en cathodes, en particulier de fiches ou broche de contact de plaquettes de circuits imprimés, caractérisé en ce qu'on utilise l'installation selon les revendications 1 à 9.

11. Procédé selon la revendication 10, pour le dépôt galvanique de revêtements en nickel ou en or sur des fiches ou broches de contact de plaquettes de circuits imprimés.

12. Procédé selon la revendication 10, caractérisé en ce qu'on utilise des densités de courant de 20 à 60 ampères/dm$^2$.

13. Procédé selon la revendication 10, caractérisé en ce qu'on utilise des vitesses d'écoulement de l'électrolyte de 1 à 3 m/s.

14. Procédé selon la revendication 10, dans lequel l'électrolyte sort avec une surpression de 0,8 à 1,0 bar.

FIG. 1a

FIG. 1 b

FIG. 1c

FIG. 2

FIG. 3

FIG. 4